Europäisches Patentamt

European Patent Office

Office européen des brevets

(11) Veröffentlichungsnummer: **0 431 296 A1**

(12) **EUROPÄISCHE PATENTANMELDUNG**

(21) Anmeldenummer: 90120306.7

(22) Anmeldetag: 23.10.90

(51) Int. Cl.⁵: **H05K 5/02**, H01F 27/06

(30) Priorität: 06.12.89 DE 8914519 U

(43) Veröffentlichungstag der Anmeldung:
**12.06.91 Patentblatt 91/24**

(84) Benannte Vertragsstaaten:
**AT BE CH DE DK ES FR GB GR IT LI LU NL SE**

(71) Anmelder: **Deutsche Telephonwerke und
Kabelindustrie Aktiengesellschaft
Wrangelstrasse 100
W-1000 Berlin 36(DE)**

(72) Erfinder: **Klingbeil, Manfred
Talberger Strasse 12m
W-1000 Berlin 47(DE)**
Erfinder: **Krispin, Harro
Beyschlagstrasse 31d
W-1000 Berlin 27(DE)**
Erfinder: **Massmann, Manfred
Hindenburgdamm 107
W-1000 Berlin 45(DE)**
Erfinder: **Pütz, Peter
Alt-Tempelhof 23
W-1000 Berlin 42(DE)**

(54) Gehäuseaufbau für Telekommunikationsanlagen.

(57) Der Gehäuseaufbau einer Telekommunikationsanlage ist derart gestaltet, daß ein einfaches Nachrüsten von Baugruppen durch den Endverbraucher selbst vorgenommen werden kann, indem die Seitenwände Haken und Lappen als Halterungselemente aufweisen. Die von der Masse her großen Bauteile, wie z. B. die Stromversorgungsbaugruppe, stützen sich auf Gewindesäulen des Bodenbleches ab.

FIG 4

EP 0 431 296 A1

# GEHÄUSEAUFBAU FÜR TELEKOMMUNIKATIONSANLAGEN

Die Erfindung betrifft einen Gehäuseaufbau für Telekommunikationsanlagen zur Aufnahme der Baugruppen der Vermittlungseinrichtung, der Stromversorgung sowie weiterer nachrüstbarer Baugruppen, der aus einer Bodenwanne und einer Haube besteht.

Gehäuse für Telekommunikationsanlagen, die aus einem Bodenblech und einer Haube zusammengesetzt sind, sind aus der DE 37 37 058 C1 bekannt. Aufbauten dieser Art, bei der die Systembaugruppen in mehreren Ebenen übereinander angeordnet sind und die durch Abstandssäulen, deren Gewindefüße und Blechlappen auf dem Bodenblech gehalten sind, sind für die Montage beim Endverbraucher durch geschultes Fachpersonal geeignet, da Eingriffe zum Anschluß der Endgeräte erforderlich sind.

Der Erfindung lag die Aufgabe zugrunde, einen Gehäuseaufbau zu schaffen, der eine leichte Montage, den Anschluß der Endgeräte und ein Nachrüsten von Baugruppen für weitere Leistungsmerkmale durch den Endverbraucher selbst gestattet. Diese Aufgabe ist durch die Erfindung gelöst, wie sie im Kennzeichnungsteil des ersten patentanspruches dargelegt ist. Die Unteransprüche beschreiben weitere vorteilhafte Ausgestaltungen.

Die Erfindung wird anhand einer aus vier Figuren bestehenden Zeichnung nachfolgend näher erläutert. Darin zeigen die

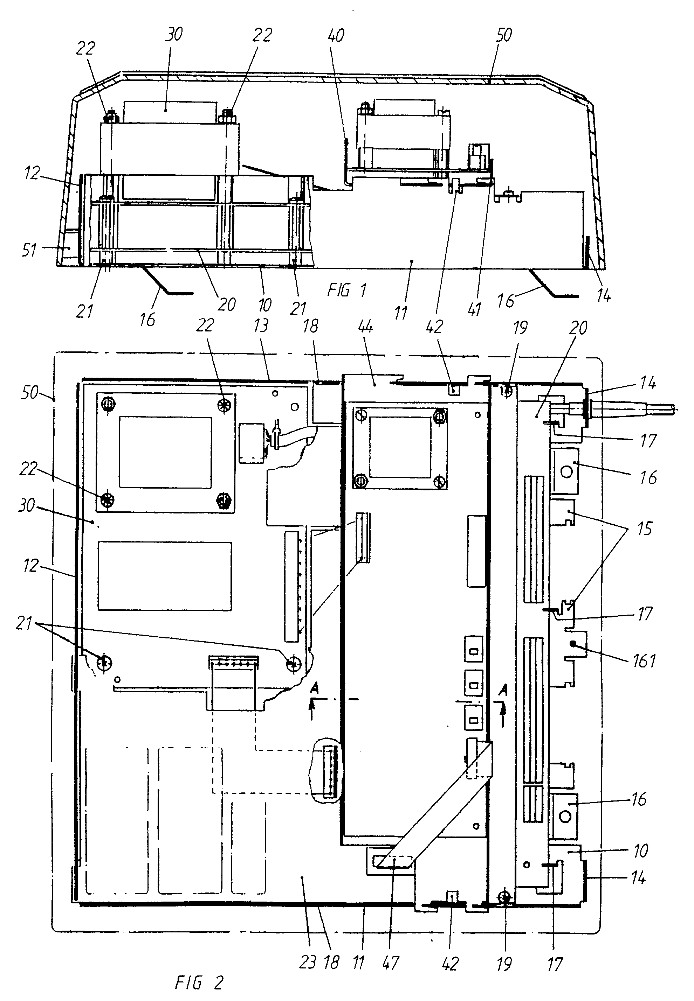

Fig. 1    eine Seitensicht der Telekommunikationsanlage, die

Fig. 2    die Sicht auf die Anlage bei abgenommener Haube, die

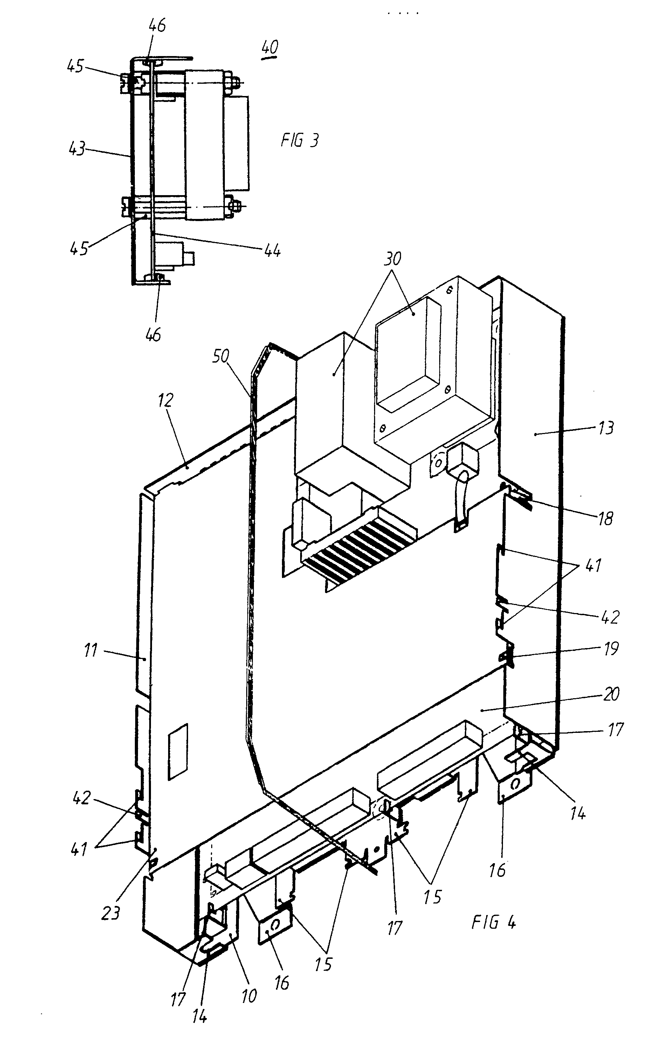

Fig. 3    einen Schnitt längs der Linie A-A durch den Anpassungsmodul und die

Fig.    4 ein perspektivische Darstellung der Telekommunikationsanlage.

In allen Figuren tragen gleiche Ausformungen gleiche Bezugszeichen.

Das Gehäuse für eine Telekommunikationsanlage besteht aus einem rechtwinkligen Bodenblech 10, dessen drei umlaufende Kanten um 90° abgewinkelt sind, die die Seitenwände 11, 12, 13 der Bodenwanne bilden. Die vierte, in der Wandmontage untere Kante des Bodenbleches, weist Blechausschnitte 14, 15, 16 auf, die teilweise abgewinkelt sind und die der Halterung von Kabeln sowie der Wandbefestigung dienen. Dabei sind die Blechausschnitte 14 zur Zugentlastung, die Blechausschnitte 15 zur Befestigung von Systemkabeln und die Blechausschnitte 16 zur Befestigung des Gehäuses durch z. B. Schrauben an einer Wand vorgesehen.

Aus dem Bodenblech 10 sind an der unteren Kante Haken 17 ausgeformt und rechtwinklig abgebogen. Die Haken 17 dienen in Verbindung mit zwei kurzen 21 und zwei längeren Gewindesäulen 22 der Halterung der vermittlungstechnischen Baugruppe 20. Die vermittlungstechnische Baugruppe 20 wird von einer Abdeckung 23 gegen Beschädigung geschützt. Die Abdeckung 23 wird in Ausnehmungen der hinteren Seitenwand 12 eingehängt, durch seitliche Stege 18 gestützt und mittels Blechschrauben 19 an gelochten Lappen der Seitenwände 11 und 13 befestigt. Die Stromversorgungsbaugruppe 30 wird durch die kurzen Gewindesäulen 21 am Bodenblech 10 abgestützt und über die längeren Gewindesäulen 22 wird der Netztransformator am Bodenblech 10 befestigt.

Um eine Erweiterung der Anlage, z. B. ein Hachrüsten einer Fernwirkeinrichtung, durch den Endverbraucher in einfacher Weise zu ermöglichen, sind die Seitenwände 11, 13 mit hintereinander liegenden Haken 41 und zwischen ihnen angeordneten Lappen 42 versehen. Die nachrüstbare Baugruppe 40 besteht aus einem U-förmigen Bodenblech 43, in dem die Leiterplatte 44, z. B. für die Anpassung der Zeichengabe, in an den Innenwänden angeordnete Führungsleisten 46 geschoben wird. Der auf der Leiterplatte 44 vorhandene Transformator für die Stromversorgung wird mittels Gewindesäulen 45 am U-förmigen Bodenblech 43 abgestützt. Durch die Verschraubung der Gewindesäulen 45 mit dem Bodenblech 43 ist zudem die Leiterplatte 44 in ihrer Lage fixiert. Die Baugruppe 40 ist durch Verhaken formschlüssig mit dem Bodenblech 10 der Telekommunikationsanlage verbunden und durch das Umbiegen der Lappen 42 ist eine Sicherung gegen ein Herausrutschen gewährleistet.

Die elektrische Verbindung zwischen nachrüstbarer Baugruppe 40 und der vermittlungstechnischen Baugruppe 20 sowie der Stromversorgungsbaugruppe 30 wird durch das Stecken eines Kabelverbinders 47 hergestellt.

Eine Haube 50 wird mittels Stegen 51 an ihren Innenwänden auf den Seitenwänden 11, 12, 13 der Bodenwanne abgestützt und durch eine Schraubverbindung 161 am Bodenblech 10 befestigt.

## Ansprüche

1.    Gehäuseaufbau für Telekommunikationsanlagen zur Aufnahme der Baugruppen der Vermittlungseinrichtung, der Stromversorgung und weiterer nachrüstbarer Baugruppen, der aus einer Bodenwanne und einer Haube besteht, dadurch gekennzeichnet, daß die Bodenwanne aus einem rechtwinkligen Bodenblech (10) gebildet wird, bei dem drei der umlaufenden Kanten zu Seitenwänden (11, 12, 13) um 90° abgewinkelt sind, daß die vierte Kante Blechausschnitte (14, 15, 16) und Haken (17) aufweist, die teilweise abgewinkelt sind, daß die Haken (17) in Verbindung mit kurzen und längeren Gewindesäulen (21, 22) als Träger- und Halteelemente für die vermittlungstechnische Baugruppe (20) dienen und die kurzen und längeren Gewindesäulen (21, 22) die Stromversorgungsbaugruppe (30) stützen.

2. Gehäuseaufbau nach Anspruch 1, dadurch gekennzeichnet, daß die Seitenwände (11, 13) Stege (18) und gelochte Lappen und die hintere Seitenwand (12) Ausnehmungen zur Aufnahme einer Abdeckung (23) aufweisen.

3. Gehäuseaufbau nach Anspruch 1, dadurch gekennzeichnet, daß die Seitenwände (11, 13) hintereinander liegende Haken (41) mit zwischen diesen angeordneten Lappen (42) tragen, zur Aufnahme einer nachrüstbaren Baugruppe (40).

4. Gehäuseaufbau nach Anspruch 3, dadurch gekennzeichnet, daß die nachrüstbare Baugruppe (40) ein Bodenblech (43) U-förmigen Profils aufweist mit an den Innenwänden angeordneten Führungsleisten (46) zur Aufnahme einer Leiterplatte (44).

FIG 1

FIG 2

FIG 3

FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 467 399  (VAN HUSEN)<br>* Spalte 2, Zeilen 43 - 61; Figuren 3-4 *<br>– – – | 1-4 | H<br>05 K 5/02<br>H 01 F 27/06 |
| A | DE-U-8 625 214  (PHILIPS PATENTVERWALTUNG)<br>* Seite 5, Zeilen 11 - 28; Figur 1 *<br>– – – | 1-4 | |
| A,D | DE-C-3 737 058  (DEUTSCHE TELEPHONWERKE UND KABELINDUSTRIE AG)<br>* Spalte 2, Zeilen 28 - 48; Figur 1 *<br>– – – | 1 | |
| A | DE-U-7 315 519  (SIEMENS AG)<br>* Seite 5, Absatz 2 *<br>– – – – – | 1 | |

RECHERCHIERTE SACHGEBIETE (Int. Cl.5)

H 05 K
H 01 F

Der vorliegende Recherchenbericht wurde für alle Patentansprüche erstellt

| Recherchenort | Abschlußdatum der Recherche | Prüfer |
|---|---|---|
| Den Haag | 07 März 91 | TOUSSAINT F.M.A. |